# EUROPEAN PATENT SPECIFICATION

(11) **EP 3 990 942 B1**
(45) Date of publication and mention of the grant of the patent: **11.03.2026**
(21) Application number: 20725576.1
(22) Date of filing: 19.05.2020
(51) Int. Cl.: G01S 7/4863, G01S 7/486, G01S 17/08

(54) **IMAGING SYSTEM AND DETECTION METHOD**
BILDGEBUNGSSYSTEM UND DETEKTIONSVERFAHREN
SYSTÈME D'IMAGERIE ET PROCÉDÉ DE DÉTECTION

(30) Priority: 27.06.2019 EP 19182966
(43) Date of publication of application: 04.05.2022
(73) Proprietor: ams International AG, 8645 Jona (CH)
(72) Inventor: HOFRICHTER, Jens, 8640 Rapperswil (CH)
(74) Representative: Epping - Hermann - Fischer
(86) International application number: PCT/EP2020/063943
(87) International publication number: WO 2020/259929

(56) References cited:
- US-A1- 2003 076 484
- US-A1- 2004 118 624
- US-A1- 2017 248 796
- US-A1- 2018 209 846

## Description

The present disclosure is related to an imaging system and a detection method.

The disclosure relates to the field of light detection and ranging systems, abbreviated LIDAR systems. Moreover, it relates to imaging systems. More specifically, it relates to imaging systems with integrated LIDAR capability for distance measurements. Particularly, it relates to high-resolution imagers with distance measurement capabilities. The imaging system may be realized as a LIDAR system, employing image sensors with in-pixel modulation. Prior art deals with optical ranging system mainly through the so-called time-of-flight, TOF, approach, where an optical pulse is emitted and the time it travels is calculated with a time-to-digital converter, TDC.

Current state-of-the-art LIDAR systems resort to three options:
(1) Scanning LIDAR systems with movable parts and sequential scanning of the surface. Such systems to date are for example employed for autonomous driving.
(2) LIDAR systems with solid-state lighting systems, where a number of dots are projected onto a surface. Such systems may be made small and compact and are in principle suitable for miniaturization and are employed in mobile devices.
(3) LIDAR systems, where a CMOS imager is used in conjunction with a receiving modulator. Such a system so far is limited to handheld devices and cannot be miniaturized, as discrete optical components are required.

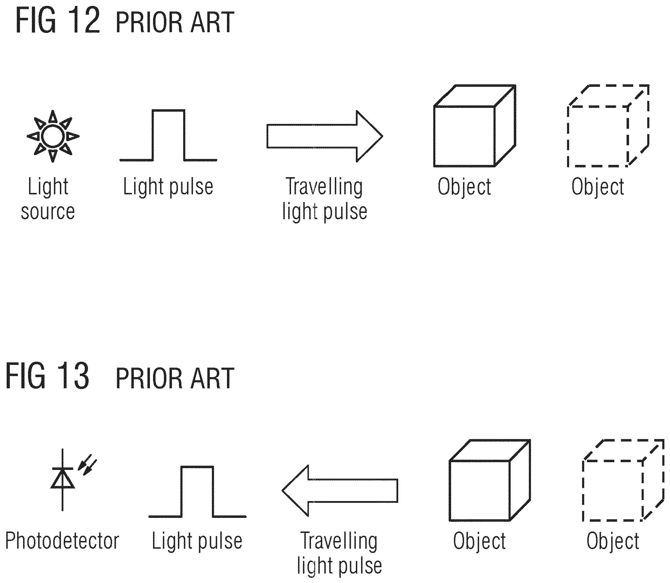

Figure 12 and Figure 13 both show the working principle of prior art approaches (1) and (2) discussed above. Figure 12 shows a LIDAR system wherein a light source (e.g., a laser) is emitting light pulses towards an object where the light pulse is reflected. Figure 13 shows the LIDAR system wherein the backward travelling light pulse is detected by an appropriate photodetector. The time difference between the light pulse emission and the receiving light pulse can be measured with a time-to-digital converter, TDC.

In both cases, a light pulse is emitted by light source (typically a laser suitable for emission of light pulses with a very short duration, typically picoseconds) and deflected onto several objects, where it is then reflected. The backward travelling light pulse is then collected by an appropriate photodetector, e.g., an avalanche photodetector \or SPAD suitable for fast light pulse detection. The time difference between the light pulse emission and the received light pulse is measured or counted by a time-to-digital converter, TDC. In such a system, typically one single laser beam or a so-called point-cloud is emitted onto the scenery. Therefore, the resolution is limited to a single or a few hundreds of pixels only.

In the third approach (3), also light pulses are employed, which are usually neither emitted by a single or a multitude of collimated laser. Rather, a light source or laser beam with a certain field-of-view, FOV, in the order of several degrees is used. After reflection, the light pulse is collected with a CMOS image sensor or sensor array. The image sensor itself is configured such that is has a modulator built on top of it to modulate the intensity or phase of the incoming signal. First, an unmodulated image Idc is recorded. Then, the modulated image Imod is acquired. The modulation is made such that at the beginning of the frame the modulator is attenuating the signal. At the end of the frame the modulator allows for full transparency and the signal is not attenuated anymore.

Now after the acquisition of both frames, the distance image is computed as a function of the modulated and the unmodulated image. Although this system works with CMOS image sensors in excess of 1 Mpixel, the integration of the optical path comprising polarization beam splitters and complex modulators remains a challenge.

Although some prior art systems appear to result in high-resolution LIDAR systems, they may be hard to be integrated due to the complex optical beam path including polarization beam splitters (PBS) as well as the complex modulator architecture employing Pockels cells as electro-optic modulators.

US 2018/0209846 A1 shows a SPAD detector for time-of-flight applications having modulated sensitivity. The sensitivity of one or more single-photon avalanche diodes (SPAD) in a SPAD detector is modulated over time. The sensitivity of all of the SPADs may be modulated, or the sensitivity of one section of the SPADs can be modulated differently from another section of the SPADs.

US 2017/0248796 A1 shows a 3D imaging system which includes an optical modulator for modulating a returned portion of a light pulse as a function of time. The returned light pulse portion is reflected or scattered from a scene for which a 3D image or video is desired. The 3D imaging system also includes an element array receiving the modulated light pulse portion and a sensor array of pixels, corresponding to the element array. The pixel array is positioned to receive light output from the element array. The element array may include an array of polarizing elements, each corresponding to one or more pixels. The polarization states of the polarizing elements can be configured so that time-of-flight information of the returned light pulse can be measured from signals produced by the pixel array, in response to the returned modulated portion of the light pulse.

It is an object to provide an imaging system and a detection method that can be miniaturized while sustaining a high pixel count.

These object is achieved by the subject-matter of the independent claims. Further developments and embodiments are described in the dependent claims.

It is to be understood that any feature described in relation to any one embodiment may be used alone, or in combination with other features described herein, and may also be used in combination with one or more features of any other of the embodiments, or any combination of any other of the embodiments unless described as an alternative. Furthermore, equivalents and modifications not described below may also be employed without departing from the scope of the imaging system and detection method, which are defined in the accompanying claims.

The following relates to an improved concept in the field of light detection and ranging, LIDAR, systems. Modulation of sensitivity of the receiver side can be achieved through in-pixel modulation of the detector array. The improved concept suggests that a modulation is performed within the pixel, rather than using a modulator on top of or attached to the receiving element. The pixels can be a modified four transistor (4T) pixel cell comprising a pinned photodiode, for instance. The detector array can be complemented with one transistor or several transistors attached to the photodiode. Said transistor or transistors can be operated as an element to modulate the effective responsivity of the photodiode by introducing a controlled leakage path. The photodiodes can be complemented with an integrated polarizer. The polarizer can be considered any array of either horizontal or vertical lines, which may be made from metal but also from other dielectric or semiconductor materials. Adjacent photodiodes might have different orientations of the polarizers to detect different polarization states of the light. Only one metal level may be present, optionally metal 1, where the remainder of the back-end-of-line is clear. However, also polarizers comprising semiconductor materials or dielectric materials can be contemplated. Moreover, high-contrast gratings could be integrated in the CMOS process by using polysilicon or other gate materials for instance.

In at least one embodiment, an imaging system comprises a light emitter, a detector array and a synchronization circuit. The detector array comprises pixels, which have a built-in modulation function. The synchronization circuit is operable to synchronize the acquisition performed by the detector array with the emission by means of the light source.

The light emitter comprises a light source such as a light emitting diode or semiconductor laser diode, for example. One type of a semiconductor laser diode includes surface emitting lasers, such as the vertical-cavity surface-emitting laser, or VCSEL, or edge emitter lasers. VCSELs combine properties such as surface emission, with design flexibility in addressable arrays, low threshold current, improved reliability and the possibility to use a wafer-level manufacturing process. For example, the light emitter is connected to a laser driver circuit. Another option for the light emitter is the used of light emitting diodes (LEDs). LEDs are also surface-emitting devices, but with the limitation that the radiation is non-coherent and has typically Lambertian emission characteristics as opposed to a directed laser beam.

Typically, the light source, or light emitter, has one or more characteristic emission wavelengths. For example, an emission wavelength of the light emitter lies in the near infrared, NIR. Other wavelengths may include visible or ultraviolet, infrared (IR) or far-infrared (FIR), for example. In one embodiment the wavelength of the light emitter might be at visible wavelengths. In another embodiment the light emission might be in the infrared wavelength range, which is invisible to the human eye. In a preferred embodiment, the emission wavelength can be 850 nm or 940 nm. A narrow wavelength bandwidth (especially over temperature) allows for more effective filtering at the receiver side, e.g. at the detector array, resulting in improved signal to noise ratio (SNR). This is supported by VCSELs, for example. This type of laser allows for emitting a vertical cylindrical beam, which renders the integration into the imaging system more straightforward. The emission of the laser can be made homogenous using one or a multitude of diffusers to illuminate the scene uniformly.

The detector array comprises one or more photodetectors, denoted pixels hereinafter. Typically, the pixels are implemented as solid-state or semiconductor photodetectors, which are arranged or integrated such as to form an array. Examples include CCD or CMOS image sensors, an array of single-photon avalanche diodes, SPADs, or other type of avalanche diodes, APDs. These types of photodetectors are sensitive to light, such as visible light, NIR, VIS, and UV, which facilitates using narrow pulse widths in emission by means of the light emitter. The detector array is arranged to acquire one or more consecutive images, denoted frames hereinafter. In order to acquire a frame the detector array may integrate incident light, using the pixels of the array, for the duration of an exposure time. Acquisition of consecutive frames may proceed with a frame rate, expressed in frames per second, for example.

The pixels have a built-in modulation function. In this context, the term "modulation" relates to a defined change of sensitivity or responsivity of pixels during the acquisition of a frame. In other words, detection by the detector array is modulated rather than the emission of light by the. This modulation can be monotonous in a mathematical sense, i.e., the change of sensitivity can be described by means of a monotonic function, e.g., a monotonic function of time. A function is called monotonic if and only if it is either entirely non-increasing, or entirely non-decreasing. In general, modulation may be monotonously increasing or decreasing. The duration of a single frame may be limited to the time during which the sensitivity is modulated. However, an advantage of the proposed concept lies in the fact that the modulation time can also be, and practice often is, faster than the duration of the frame. This renders the proposed concept different from the common time-of-flight (ToF), which relies on the ability to conduct an actual time measurement of emitted pulse and corresponding reflected pulse in a stop-watch manner, e.g., by means of time-to-digital converters (TDCs).

The synchronization circuit is arranged to synchronize the emission of light by means of the light emitter on one side and detection of light by means of the detector array on the other side. The synchronization circuit may control a delay between emission of light, e.g., pulses, and a time frame for detection. For example, a delay between the beginning of the light pulse and the beginning of detection may be set, e.g., depending on a distance or distance range to be detected. The time it takes to finish a distance measurement cycle depends on the distance between the imaging system and an external target.

The light emitter emits light during operation of the imaging system, e.g., towards a scene including an external target or object. The emitted light eventually hits the external target, gets reflected or scattered at the target, and returns to the imaging system, where the detector array eventually detects the returning light. Light returning from a closer target in the scene meets a different stage of modulation in the receiver than light returning from a target farther away in the scene. Thus, the distance is encoded in the signals generated by the pixels, or by the image created from the array. The distance to the point of reflection or scattering can be calculated from the image, e.g., by evaluating relative intensities on a per pixel basis or from the entire image. This approach is different from the common time-of-flight concept, which relies on measuring a time between emitting light and receiving light, e.g., emitting a given light pulse and receiving said pulse.

The imaging system according to the improved concept allows for reducing the need for complex receiver architectures. Instead, the system complexity is reduced by introducing in-pixel modulation at the receiver. Such an in-pixel modulation scheme can be fabricated very cost-effectively within a CMOS image sensor process and does not require Pockels Cells being made from lithium niobate type of materials or polymer films exhibiting an electro-optical effect. This allows for constructing a solid state LIDAR system without the need for moving parts or a very complex or very costly receivers. The LIDAR system can be compact and cost-efficient, and at the same time has a resolution of that of modern CMOS image sensors (e.g., several Mpixels).

The optical beam path is simplified thus enabling integration of the polarization beam splitter (PBS) into the CMOS image sensor. In fact, the complexity of the receiver can be largely reduced alleviating the need of complex Pockels cells and other types of either costly (lithium niobate) or unreliable (polymer) electro-optical modulators. Moreover, the improved concept reduces the complexity of the receiving beam path by replacing elements such as a polarization beam splitter with integrated polarization sensitive photodiodes or photodetectors with integrated polarizers. This disclosure incorporates the disclosure of document EP 3261130 A1 as a reference, where a polarization sensitive photodiode is described.

In at least one embodiment, at least the detector array and the synchronization circuit are integrated into a same chip. For example, the chip comprises a common integrated circuit into which at least the detector array and synchronization circuit are integrated. Typically, the light emitter and the common integrated circuit are arranged on and electrically contacted to each other via a shared carrier or substrate. However, in other implementations the light emitter may also be integrated into the common integrated circuit.

Integration allows for compact design, reducing board space requirements, enabling low-profile system designs in restricted space designs. Additionally, the complexity of the beam path can be reduced. Implementation on a same chip, e.g. embedded in a same sensor package, allows for an imaging system which can observe a complete field of view (FOV) at once, called Flash systems. Such imaging system may emit pulses of light, such as in the infrared. A portion of that energy is returned and converted in distance and optionally speed, for example.

In at least one embodiment, the detector array comprises pixels, which have a polarizing function. For example, integrated polarization-sensitive photodiodes can be used. The detector array may have on-chip polarizers associated with the pixels, respectively. Such a structure may be integrated using CMOS technology. Alternatively, the polarizers can be placed on-chip using an air-gap nano-wire-grid coated with an anti-reflection material that suppresses flaring and ghosting. Such an on-chip design reduces polarization crosstalk and improves extinction ratios. Alternatively, the detector array may be complemented with a layer of polarizers arranged above the pixels, respectively. The layer of polarizers may not necessarily be integrated with the detector array. For example, the layer of polarizers comprises a number of polarizers which are arranged in the layer such that they coincide with respective pixels when mounted on top of the detector array. A possible embodiment of detector array with pixels, which have a polarizing function, is disclosed in EP 3261130 A1 which is hereby incorporated by reference.

During operation of the imaging system a scene may be illuminated using the light emitter. In general, the scene comprises several external targets which each may reflect or scatter light. The reflection or scattering of light off of the targets typically produces polarized light, such as linearly polarized light in a plane perpendicular to the incident light. Polarization may further be affected by material properties of the external targets, e.g. properties of their surfaces. Polarization may thus be visible in an image acquired by the detector array. For example, by illuminating the scene typically a number of external targets with different distances are acquired in the image. A given target, however, may show similar or same polarization as its properties, characteristic for their surfaces, for example, may not change considerably over the illuminated surface. In contrast, other targets at different distances may show different polarization. Thus, pixels which have a polarizing function may further increase contrast and signal-to-noise ratio in the resulting image so that different external targets can be distinguished in the image more easily.

A light source such a VCSEL may generate polarized light. The object or external target may change or rotate the polarized light. Thus, an array with pixels having different polarization is able to generate more information about the object and may increase accuracy of the distance measurement.

In at least one embodiment, adjacent pixels have orthogonal polarization functions. Using adjacent pixels with different polarization functions allows for the detection of more linear angles of polarized light, e.g. 0° and 90°, or 180° and 270°. This is possible through comparing the rise and fall in intensities transmitted between adjacent pixels, for example. The adjacent pixels may be considered as groups in order to calculate degree and/or direction of polarization.

In at least one embodiment, the modulation function is achieved by a modulating element. For example, the modulating element controls sensitivity and/or responsivity of pixels of the detector array.

In at least one embodiment, the modulating element introduces a leakage current which is linear or non-linear to an applied voltage. Voltage can be regulated using known components such as voltage regulators. This allows for controlled and repeatable leakage currents.

In at least one embodiment, a leakage current that flows through the modulating element has a first value at a start of a frame and a second value at the end of the frame, wherein the first value is higher than the second value. Alternatively, the first value is lower than the second value. The rise or fall of the leakage current due to modulation is encoded in the image which is acquired by the detector array. For example, intensities in the image allow for determining distance information from the resulting image.

In at least one embodiment, a leakage current that flows through the modulating element monotonously decreases from a first value to a second value during a frame.

In at least one embodiment, the modulating element is a transistor. An example involves a leakage control transistor. In at least one embodiment, the emission wavelength of the light emitter is larger than 800 nm and smaller than 10.000 nm. In at least one embodiment, the emission wavelength of the light emitter is in between 840 nm and 1610 nm. Detection in these spectral ranges lies in the infrared and results in robust emission and detection. Furthermore, light in these spectral ranges is essentially invisible to and disguised from human's vision.

In at least one embodiment, according to a detection method a scene is illuminated with a first and a second light pulse. From the first light pulse a first image is acquired by a detector array having a constant sensitivity. From the second light pulse a second image is acquired by the detector array having a sensitivity increasing with time.

In at least one embodiment, a distance of objects of the scene is determined depending on the first and second image. For example, the distance of objects of the scene is inferred from a ratio of the second image and the first image.

In at least one embodiment, a LIDAR image is inferred from a ratio of the second image to the first image and distance information of the scene is determined from the LIDAR image. A distance to one or more objects can be concurred from relative intensities in the LIDAR image. For example, as the sensitivity of the detector is modulated, the distance and relative distance of objects is encoded in the LIDAR image. For example, close objects show different intensity than those farther away. These differences may be apparent in the LIDAR image and provide a measure of distance.

In at least one embodiment, the scene is illuminated by a light source and the first and the second light pulse have identical duration and height.

In at least one embodiment a vehicle, such as a car or other motor vehicle, comprises an imaging system according to the improved concept discussed below. A board electronics, such as Advanced Driver Assistance System, ADAS, is embedded in the vehicle. The imaging system is arranged to provide an output signal to the board electronics. Possible applications include automotive such as autonomous driving, collision prevention, security and surveillance, as well as industry and automation and consumer electronics.

Further implementations of the detection method are readily derived from the various implementations and embodiments of the imaging system and vehicle and vice versa.

In the following, the concept presented above is described in further detail with respect to drawings, in which examples of embodiments are presented. In the embodiments and Figures presented hereinafter, similar or identical elements may each be provided with the same reference numerals. The elements illustrated in the drawings and their size relationships among one another, however, should not be regarded as true to scale, rather individual elements, such as layers, components, and regions, may be exaggerated to enable better illustration or a better understanding.
- Figure 1: shows an example of the imaging system.
- Figure 2: shows an example embodiment of a detector array with polarization function,
- Figure 3: shows a cross section of an example detector array with a high-contrast grating polarizer,
- Figure 4: shows an example embodiment of a modulation element,
- Figure 5: shows another example embodiment of a modulation element,
- Figure 6: shows another example embodiment of a modulation element,
- Figure 7: shows another example embodiment of a modulation element,
- Figure 8: shows another example embodiment of a modulation element,
- Figure 9: shows an example embodiment of a detection method,
- Figure 10: shows an example embodiment of a detection method,
- Figure 11: shows an example timing diagram of the light source,
- Figure 12: shows an example embodiment of a prior art LIDAR detection method, and
- Figure 13: shows another example embodiment of a prior art LIDAR detection method.

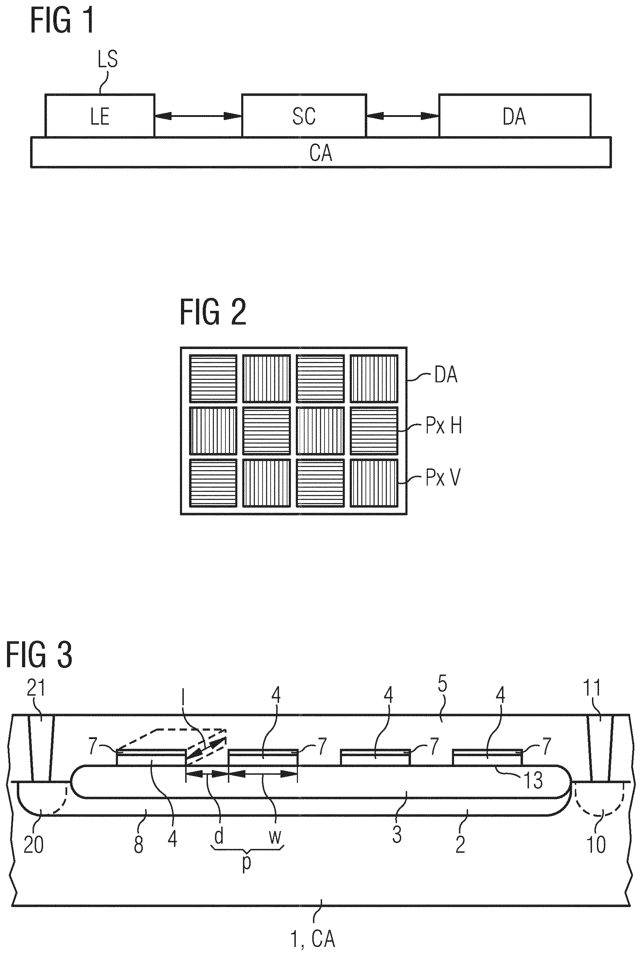

Figure 1 shows an example imaging system. The imaging system comprises a light source LS, a detector array DA and a synchronization circuit SC, which are arranged contiguous with and electrically coupled to a carrier CA. For example, the carrier comprises a substrate to provide electrical connectivity and mechanical support. The detector array and the synchronization circuit are integrated into a same chip CH which constitutes a common integrated circuit. Typically, the light source and the common integrated circuit are arranged on and electrically contacted to each other via the carrier. The components of the imaging system are embedded in a sensor package (not shown). Further components such as a processing unit, e.g. a processor or microprocessor, to execute the detection method and ADCs, etc. are also arranged in the sensor package and may be integrated into the same integrated circuit.

The light source LS comprises a light emitter such as a surface emitting laser, e.g., a vertical-cavity surface-emitting laser, or VCSEL. The light emitter has one or more characteristic emission wavelengths. For example, an emission wavelength of the light emitter lies in the near infrared, NIR, e.g. larger than 800 nm and smaller than 10.000 nm. LIDAR applications may rely on the range of emission wavelength of the light emitter is in between 840 nm and 1610 nm which results in robust emission and detection. This range can be offered by the VCSEL. The light source such a VCSEL may generate a polarized light. An external target or object may change or rotate the polarized light. Thus, an array with pixels having different polarization is able to generate more information about the object and to increase accuracy of the distance measurement.

The detector array DA comprises one or more photodetectors, or pixels. The array of pixels form an image sensor. The photodetectors may be a photodiode, e.g. a pinned photodiode, a pin photodiode or another photodiode. The detector array comprises an array of detecting elements such as an array of photodiodes. The pixels are polarization sensitive. Adjacent pixels of the image sensor are polarization sensitive, each having an orthogonal state of polarization arranged in a checker-board pattern. This will be discussed in more detail below. The synchronization circuit SC is arranged in the same sensor package, and, in fact, integrated in the common integrated circuit. The synchronization circuit SC is arranged to synchronize emission of light, by means of the light emitter and/or detection by means of the detector array, e.g. as frames A and B.

Figure 2 shows an example embodiment of a detector array with polarization function. The detector array DA, or image sensor, comprises pixels which are arranged in a pixel map as shown. The image sensor can be characterized in that adjacent pixels have different states of polarization. The drawings shows a detector array with on-chip polarizers associated with the pixels, respectively. Such a structure may be integrated using CMOS technology. Adjacent pixels have orthogonal polarization functions, e.g., pixels PxH with horizontal polarization and pixels PxV with vertical polarization. Embodiments of said detector array are disclosed in in EP 3261130 A1 which is hereby incorporated by reference.

Figure 3 shows a cross section of an example detector array with a high-contrast grating polarizer. This example corresponds to Figure 1 of EP 3261130 A1 and is cited here for easy reference. The remaining embodiments of detector arrays in EP 3261130 A1 are not excluded but rather incorporated by reference.

The photodetector device, detector array, shown in Figure 3 comprises a substrate 1 of semiconductor material, which may be silicon, for instance. The photodetectors, or pixels, of the array are suitable for detecting electromagnetic radiation, especially light within a specified range of wavelengths, such as NIR, and are arranged in the substrate 1, e.g. in the common integrated circuit. The detector array may comprise any conventional photodetector structure and is therefore only schematically represented in Figure 3 by a sensor region 2 in the substrate 1. The sensor region 2 may extend continuously as a layer of the substrate 1, or it may be divided into sections according to a photodetector array.

The substrate 1 may be doped for electric conductivity at least in a region adjacent to the sensor region 2, and the sensor region 2 may be doped, either entirely or in separate sections, for the opposite type of electric conductivity. If the substrate 1 has p-type conductivity the sensor region 2 has n-type conductivity, and vice versa. Thus a pn-junction 8 or a plurality of pn-junctions 8 is formed at the boundary of the sensor region 2 and can be operated as a photodiode or array of photodiodes by applying a suitable voltage. This is only an example, and the photodetector array may comprise different structures.

A contact region 10 or a plurality of contact regions 10 comprising an electric conductivity that is higher than the conductivity of the adjacent semiconductor material may be provided in the substrate 1 outside the sensor region 2, especially by a higher doping concentration. A further contact region 20 or a plurality of further contact regions 20 comprising an electric conductivity that is higher than the conductivity of the sensor region 2 may be arranged in the substrate 1 contiguous to the sensor region 2 or a section of the sensor region 2. An electric contact 11 can be applied on each contact region 10 and a further electric contact 21 can be applied on each further contact region 20 for external electric connections.

An isolation region 3 may be formed above the sensor region 2. The isolation region 3 is transparent or at least partially transparent to the electromagnetic radiation that is to be detected and has a refractive index for the relevant wavelengths of interest. The isolation region 3 comprises a dielectric material like a field oxide, for instance. If the semiconductor material is silicon, the field oxide can be produced at the surface of the substrate 1 by local oxidation of silicon (LOCOS). As the volume of the material increases during oxidation, the field oxide protrudes from the plane of the substrate surface as shown in Figure 3.

Grid elements 4 are arranged at a distance d from one another on the surface 13 of the isolation region 3 above the sensor region 2. For example, the grid elements 4 can be arranged immediately on the surface 13 of the isolation region 3. The grid elements 4 may have the same width *w,* and the distance d may be the same between any two adjacent grid elements 4. The sum of the width *w* and the distance d is the pitch p, which is a minimal period of the regular lattice formed by the grid elements 4. The length *l* of the grid elements 4, which is perpendicular to their width *w,* is indicated in Figure 3 for one of the grid elements 4 in a perspective view showing the hidden contours by broken lines.

The grid elements 4 are transparent or at least partially transparent to the electromagnetic radiation that is to be detected and have a refractive index for the relevant wavelengths. The grid elements 4 may comprise polysilicon, silicon nitride or niobium pentoxide, for instance. The use of polysilicon for the grid elements 4 has the advantage that the grid elements 4 can be formed in a CMOS process together with the formation of polysilicon electrodes or the like. The refractive index of the isolation region 3 is lower than the refractive index of the grid elements 4. The isolation region 3 is an example of the region of lower refractive index recited in the claims.

The grid elements 4 are covered by a further region of lower refractive index. In the photodetector device according to Figure 3, the grid elements 4 are covered by a dielectric layer 5 comprising a refractive index that is lower than the refractive index of the grid elements 4. The dielectric layer 5 may especially comprise borophosphosilicate glass (BPSG), for instance, or silicon dioxide, which is employed in a CMOS process to form inter-metal dielectric layers of the wiring.

The grid elements 4 are thus embedded in material of lower refractive index and form a high-contrast grating polarizer.

An antireflective coating 7 may be applied on the grid elements 4. It may be formed by removing the dielectric layer 5 above the grid elements 4, depositing a material that is suitable for the antireflective coating 7, and filling the openings with the dielectric material of the dielectric layer 5. The antireflective coating 7 may especially be provided to match the phase of the incident radiation to its propagation constant in the substrate 1. For example, if the substrate 1 comprises silicon, the refractive index of the antireflective coating 7 may be at least approximately the square root of the refractive index of silicon. Silicon nitride may be used for the antireflective coating 7, for instance.

The array of grid elements 4 forms a high-contrast grating, which is comparable to a resonator comprising a high quality-factor. For the vector component of the electric field vector that is parallel to the longitudinal extension of the grid elements 4, i.e., perpendicular to the plane of the cross sections shown in Figure 3, the high-contrast grating constitutes a reflector. Owing to the difference between the refractive indices, the optical path length of an incident electromagnetic wave is different in the grid elements 4 and in the sections of the further region of lower refractive index 5, 15 located between the grid elements 4. Hence an incident electromagnetic wave reaches the surface 13, 16 of the region of lower refractive index 3, 6, which forms the base of the high-contrast grating, with a phase shift between the portions that have passed a grid element 4 and the portions that have propagated between the grid elements 4.

The high-contrast grating can be designed to make the phase shift π or 180° for a specified wavelength, so that the portions in question cancel each other. The high-contrast grating thus constitutes a reflector for a specified wavelength and polarization.

When the vector component of the electric field vector is transverse to the longitudinal extension of the grid elements 4, the electromagnetic wave passes the grid elements 4 essentially undisturbed and is absorbed within the substrate 1 underneath. Thus electron-hole pairs are generated in the semiconductor material. The charge carriers generated by the incident radiation produce an electric current, by which the radiation is detected. Optionally, a voltage is applied to the pn-junction 8 in the reverse direction.

The grid elements 4 may comprise a constant width w, and the distance d between adjacent grid elements 4 may also be constant, so that the high-contrast grating forms a regular lattice. The pitch p of such a grating, which defines a shortest period of the lattice, is the sum of the width *w* of one grid element 4 and the distance d. For the application of the array of grid elements 4 as a high-contrast grating polarizer, the pitch p is typically smaller than the wavelength of the electromagnetic radiation in the material of the region of lower refractive index n_{low1} and/or in the further region of lower refractive index n_{low2} or even smaller than the wavelength in the grid elements 4. In the region of lower refractive index n_{low1} the wavelength λ₀ in vacuum of the electromagnetic radiation to be detected becomes λ₁ = λ₀/n_{low1}. In the further region of lower refractive index n_{low2} the wavelength becomes λ₂ = λ₀/n_{low2}. If n_{high} is the refractive index of the grid elements 4, the wavelength λ₀ becomes λ₃ = λ₀/n_{high} in the grid elements 4, λ₃ < λ₀/n_{low1}, λ₃ < λ₀/n_{low2}. This dimension denotes a difference between the high-contrast grating used as a polarizer in the photodetector device described above and a conventional diffraction grating.

The pitch p may be larger than a quarter wavelength of the electromagnetic radiation in the grid elements 4. If the wavelength of the electromagnetic radiation to be detected is λ₀ in vacuum, p > λ₃/4 = λ₀/(4n_{high}). This distinguishes the high-contrast grating used as a polarizer in the detector array described above from deep-subwavelength gratings. The length l of the grid elements 4 is optionally larger than the wavelength λ₃ = λ₀/n_{high} of the electromagnetic radiation in the grid elements 4.

Therefore, the high-contrast grating based polarizer alleviates drawbacks of tight fabrication tolerance and layer thickness control as for diffraction gratings; and the necessity of very small structures and thus very advanced lithograph as for deep sub-wavelength gratings. The detector array with high-contrast grating polarizer can be used for a broad range of applications. Further advantages include an improved extinction coefficient for states of polarization that are to be excluded and an enhanced responsivity for the desired state of polarization.

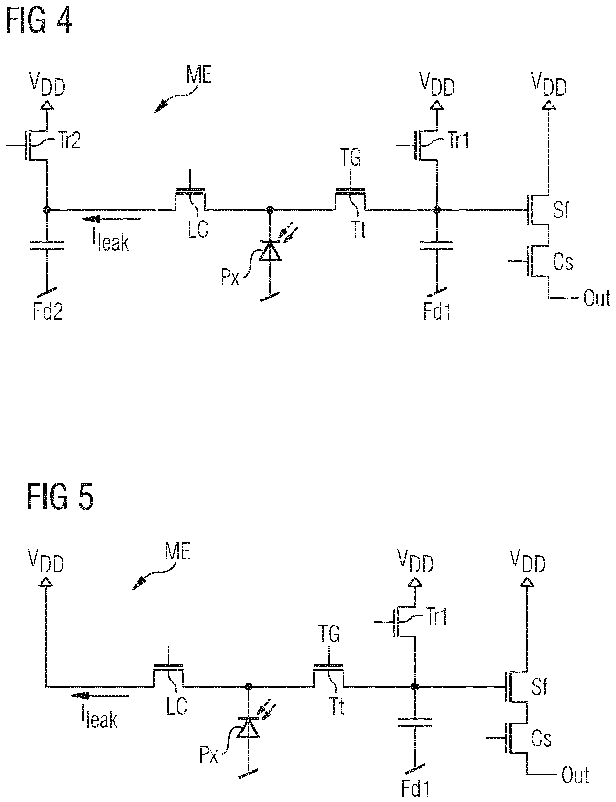

Figure 4 shows an example embodiment of a modulation element. The drawings shows a circuit layout of a pixel architecture, or 4T pixel cell, of the detector array DA implemented as an image sensor. The pixel Px is connected as a 4T pixel architecture. The 4T pixel architecture comprises a transfer transistor Tt with transfer gate TG, a first reset transistor Tr1 connected to a first floating diffusion Fd1 and a source follower Sf, a column select Cs transistors which provide an output terminal Out. The pixel Px is further connected to the modulation element ME which comprises a leakage control element LC, a second reset transistor Tr2 and a second floating diffusion Fd2. Vdd indicates the supply rail.

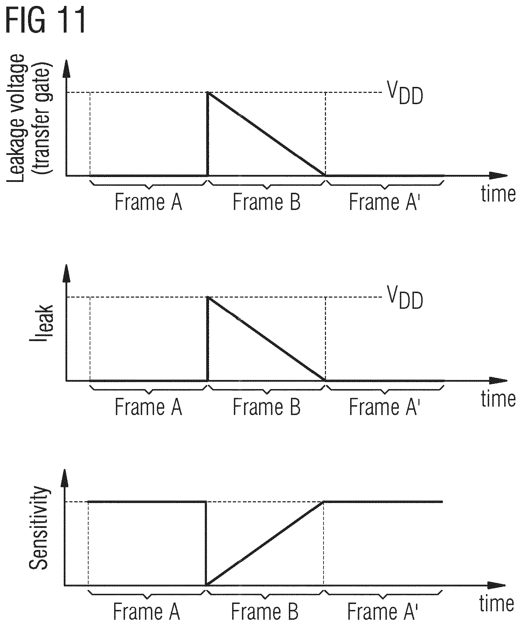

The modulation element ME comprises a leakage control element LC, which is responsible for re-routing a certain amount of charge per unit time to a position different from a floating diffusion. This re-routing can be controlled using the gate of the leakage control element LC. The floating diffusion of the 4T pixel cell holds the relevant charge information. That charge is intentionally re-routed so that the responsivity is reduced. In fact, there is a leakage path introduced to the second floating diffusion Fd2 reducing the responsivity of the photodetector Px. The modulation shall proceed monotonously during the modulation frame B as shown in Figure 11, for example.

Figure 5 shows another example embodiment of a modulation element. The drawings shows a circuit layout of a pixel architecture of the detector array DA implemented as an image sensor. The 4T pixel cell is that of Figure 4, however, modified. The pixel Px is connected to the modulation element ME which comprises the leakage control element LC but not a second reset transistor Tr2 or a second floating diffusion Fd2. Instead the leakage control element LC is connected to the supply rail Vdd.

The leakage control element LC redirects charge to the supply rails (e.g. Vdd) during the acquisition of a frame. In fact, there is a leakage path introduced to the supply rails reducing the responsivity of the photodetector. The leakage control can be monotonous such that a frame starts with a reduced sensitivity which is then monotonously increasing. This concept enables objects further away from the imaging system to contribute more signal.

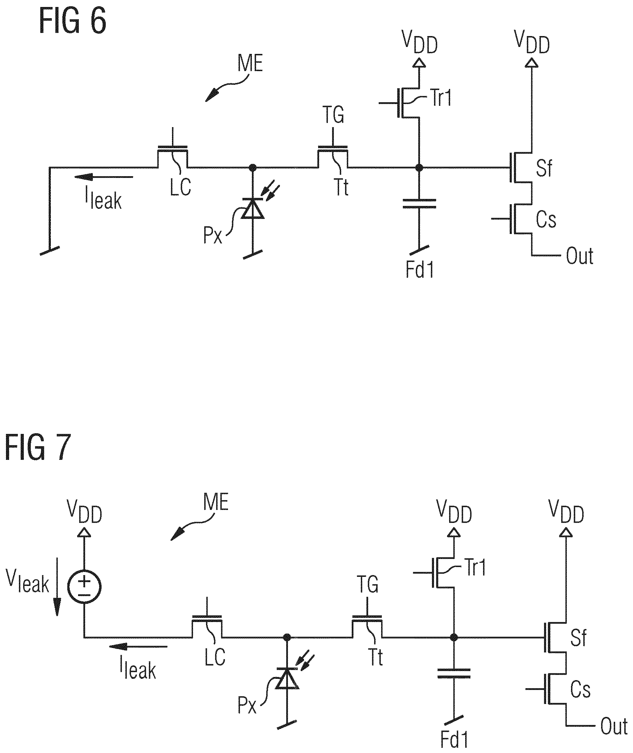

Figure 6 shows another example embodiment of a modulation element. The drawings shows a circuit layout of Figure 5. However, the leakage control element LC is connected to ground instead of supply rail Vdd.

In the embodiments mentioned above the leakage control element is optionally linear. This means that the leakage current is proportional to the control voltage applied to this element, e.g. via its gate. Alternatively, the leakage control element can be non-linear. Thus, the sensitivity of the photodetector during a frame may rise non-linearly or linearly. In both cases, the change of sensitivity during a given frame is monotonous, i.e. either monotonously increasing or decreasing.

Figure 7 shows another example embodiment of a modulation element. The drawing shows a circuit layout of a pixel architecture similar to that of Figure 4. The 4T pixel cell is that of Figure 4. However, the modulation element ME is modified. The pixel Px is connected to the modulation element ME which comprises the leakage control element LC but not a second reset transistor Tr2 or a second floating diffusion Fd2. Instead the leakage control element LC is connected to the supply rail Vdd via a voltage source VS to apply a control voltage Vleak. The voltage between the leakage control element and the supply rail (VDD) can be varied, e.g. linearly or non-linearly, during acquisition of a frame. During this frame, the leakage control element (i.e., a MOSFET) is operated in weak inversion and behaves like a resistor. By linearly varying the voltage Vleak in time, the leakage current Ileak is linearly varied in time also. By non-linearly varying the voltage Vleak in time, the leakage current Ileak is linearly varied in time also.

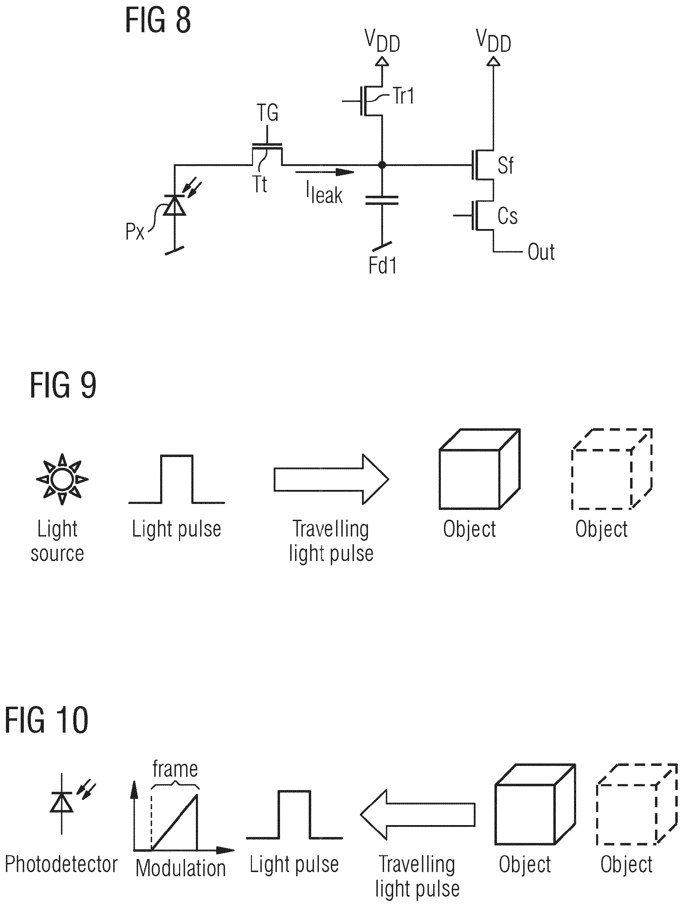

Figure 8 shows another example embodiment of a modulation element. In this embodiment there is no additional leakage control element, but rather the transfer gate Tg of the transfer transistor Tt of the 4T pixel cell is operated as a leakage control element in part of the acquisition of a frame. During a frame, the transfer gate can be kept slightly opened thus introducing a time-dependent leakage path to the first floating diffusion Fd1, which is reset by the reset transistor Tr before the actual charge transfer. During read-out, the transfer gate Tg is operated conventionally as in a 4T pixel cell, namely it isolates the photodetector from the first floating diffusion Fd1 to not alter the conversion gain, e.g. of a read-out circuit.

Figure 9 shows an example embodiment of a detection method, e.g. a LIDAR detection method. The light source, e.g. the VCSEL laser, LED, laser or flash lamp, emits an unmodulated light pulse. The light pulse is characterized in that it is synchronized with the photodetector. After being emitted either light pulse travels until it is reflected or scattered at one or more objects of the scenery. The reflected or scattered light returns to the imaging system where the detector array eventually detects the returning light. The backward travelling path is shown in Figure 10.

Figure 10 shows an example embodiment of a detection method, e.g. a LIDAR detection method. This drawing shows the backward path of the LIDAR system. A light pulse emitted by the light emitter travels until it is reflected or scattered at one or more objects of the scenery. The reflected or scattered light returns to the imaging system where the detector array eventually detects the returning light. The reflected or scattered light pulse is modulated within a photodetector of the detector array during detection. Modulation function is integrated in the pixel. The modulation affects the sensitivity or responsiveness of a pixel. For example, sensitivity during a frame is monotonously increasing or monotonously decreasing as a function of time. The modulated sensitivity in the drawing starts at low and increases to high sensitivity.

The imaging system, or LIDAR system, due to its arrangement, e.g. in a compact sensor package, which may also include dedicated optics, allows for observing a complete field of view (FOV) at once, called a Flash system. Flash typically works well for short to mid-range (0-100m); and by capturing a complete scene at once also several objects and objects with high relative speeds can be detected properly. The synchronization circuit controls a delay between emission of light and a time frame for detection, e.g. the delay between emission of the pulses and a time frame for detection. The delay between an end of the pulse and a beginning of detection may be set, e.g. depending on a distance or distance range to be detected.

The detection may involve this example sequence of operation:
1) Emission of a light pulse with constant irradiance,
2) Acquisition of a "constant image", e.g. as first image during a first frame,
3) Emission of another light pulse with constant irradiance,
4) Acquisition of a "modulated image" , e.g. as second image during a second frame,
5) Calculation of a "LIDAR image" by division of "modulated image" by "constant image".

Figure 11 shows an example timing diagram of the light source. The drawing shows leakage voltage, leakage current and sensitivity as functions of time, respectively. During a first integration of a first frame A, a steady-state image, or "constant image", is acquired. The purpose is to acquire a steady-state or dc image. Such image may be grayscale or color depending on the application. In a second integration of a second frame B, the "modulated image" is acquired. During the modulation a voltage, e.g. the leakage voltage Vleak, is applied to the leakage control element LC as discussed above. In the second frame, frame B, the sensitivity of the pixels is modulated, for example monotonically, i.e. sensitivity increases or decreases linearly or non-linearly. The distance image, or "LIDAR image", is then composed by dividing the modulated image from frame B by the non-modulated image from frame A, or by performing another mathematical calculation. In the "LIDAR image" items being further away in the scene show a different intensity than close objects.

In one example, the light source generates the light pulse with a duration that is smaller than a duration of frame A and a duration of frame B. For example, the duration of the light pulse may be less than 2 ns or less than 1 ns or less than 0,5 ns. The duration of the frame B may be higher than 1 ms or higher than 5 ms or higher than 10 ms or higher than 20 ms. The photodetector measures (e.g. integrates) during the frame B. The photodetector may detect light during the complete duration of the frame B or during most of the duration of the frame B. The light source generates the light pulse at the start of frame B or shortly after the start of frame B. The object reflects the light pulse. A point of time at which the reflected light pulse reaches the photodetector depends on the distance of the object from the photodetector. During frame B, the photodetector has a sensitivity that increases with time. In case of a short distance, the photodetector has a low sensitivity when the reflected light pulse hits the photodetector. In case of a long distance, the photodetector has a high sensitivity when the reflected light pulse hits the photodetector. Thus, a value of the signal generated by the photodetector at the end of frame B depends on the amount of light in the reflected light pulse and the point of time at which the reflected light pulse arrives at the photodetector.

During frame A and frame A', the photodetector has a constant sensitivity. Thus, a value of the signal generated by the photodetector at the end of frame A depends on the amount of light in the reflected light pulse and is independent from the point of time at which the reflected light pulse arrives at the photodetector. The distance of the object from the photodetector can be calculated by using the value of the signal generated by the photodetector at the end of frame B and the value of the signal generated by the photodetector at the end of frame A or A'.

The timing discussed above can also be applied to the embodiment of Figure 8, i.e. there is no additional leakage control element, but rather the transfer gate Tg of the transfer transistor Tt of the 4T pixel cell is operated as a leakage control element in part of the acquisition of a frame. In this case the leakage voltage corresponds to a control voltage to be applied at the transfer gate Tg of the transfer transistor Tt.

Emission of pulses and detection by means of the detector, with modulated sensitivity or not, e.g., as frames A or B, is synchronized by means of a synchronization circuit. In fact, light emitter, detector array and synchronization circuit may all be arranged in a same sensor package, wherein at least the detector array and synchronization circuit are integrated in the same integrated circuit. Further components such as a microprocessor to execute the detection method and ADCs, etc. may also be arranged in a same sensor package and integrated into the same integrated circuit.

The embodiments shown in Figures 1 to 11 as stated above represent example embodiments of the improved imaging system and detection method, therefore they do not constitute a complete list of all embodiments according to the improved imaging system and detection method. An actual imaging system and detection method may vary from the embodiments shown in terms of circuit parts, shape, size and materials, for example.

In the embodiment, the leakage control element comprises a transistor with a relatively long gate length.

It should be noted that the examples above are non-exhaustive. This approach can be applied all the way from 3T pixel cells up to high-end HDR 8-transistor pixel arrays. The examples given above are all derived from the 4T pixel architecture. Also, the polarization property of the photodetectors does not need to be implemented in low-cost applications where size and cost are critical.

The applications of the imaging system may e.g. comprise
- Automotive: Autonomous driving, collision prevention
- Security and surveillance
- Industry and automation
- Consumer electronics

This imaging system is used for LIDAR and TOF systems, but not from a point-cloud perspective but enables high-resolution LIDAR systems suitable for various applications, in particular automotive, autonomous driving, robotics, drones and industrial applications.

The technology described in this disclosure provides advantages over systems working with single laser beam deflection of point clouds of several hundreds of pixels only.

The imaging system realizes a control of the VCSEL power which could be implemented in CMOS image sensor designs.

The detection method may be implemented by the imaging system described above. The light source may be named light emitter. The image sensor may be named detector array.

### Reference numerals

- 1: substrate
- 2: sensor region
- 3: isolation region
- 4: grid element
- 5: dielectric layer
- 7: antireflective coating
- 8: pn junction
- 10: contact region
- 11: contact
- 13: surface
- 20: further contact region
- 21: further contact
- d: distance
- p: pitch
- w: width
- A, A': frame
- B: frame
- CA: carrier, substrate
- CH: chip
- Cs: column select
- DA: detector array
- Fd1: first floating diffusion
- Fd2: second floating diffusion
- LC: leakage control element
- LE: light emitter
- ME: modulation element
- Px: pixel
- PxH: pixel with horizontal polarizer
- PxV: pixel with vertical polarizer
- SC: synchronization circuit
- Sf: source follower
- Tr1: first reset transistor
- Tr2: second reset transistor
- Tt: transfer transistor
- TG: transfer gate
- Vdd: supply rail

## Claims

1. An imaging system comprising:
- a light source (LS),
- a detector array (DA) which comprises pixels (Px), wherein the pixels have a built-in modulation function changing sensitivity or responsivity of pixels during the acquisition of a frame, and
- a synchronization circuit (SC) to synchronize the acquisition performed by detector array (DA) with the light source (LS), wherein the light source is operable to emit:
- a first light pulse to acquire a first image by a detector array (DA) having a constant sensitivity, and
- a second light pulse to acquire a second image by the detector array having a sensitivity increasing with time, and wherein
- the modulation function is a monotonic function of time and monotonously increasing or decreasing.

2. The imaging system according to claim 1, wherein
- at least the detector array (DA) and the synchronization circuit (SC) are integrated into a same chip (CH) and/or
- the imaging comprises a sensor package, which encloses the detector array (DA) and the synchronization circuit (SC) integrated into the same chip (CH) as well as the light source (LS).

3. The imaging system according to claim 1 or 2, where the modulation function is achieved by a modulating element (ME).

4. The imaging system according to claim 3, where the modulating element (ME) introduces a leakage current linear to an applied voltage.

5. The imaging system according to one of claims 1 to 4, where the pixels (Px) have a polarizing function.

6. The imaging system according to claim 5, where adjacent pixels (Px) have orthogonal polarization functions.

7. The imaging system according to one of claims 4 to 6, where a leakage current that flows through the modulating element (ME) has a first value at a start of a frame and a second value at the end of the frame, wherein the first value is higher than the second value.

8. The imaging system according to one of claims 4 to 7, where a leakage current that flows through the modulating element (ME) monotonously decreases from a first value to a second value during a frame B.

9. The imaging system according to one of claims 4 to 8, where the modulating element (ME) is a transistor, such as a leakage control transistor.

10. The imaging system according to one of claims 1 to 9, where the emission wavelength of the light source (LS) is larger than 800 nm and smaller than 10000 nm.

11. The imaging system according to one of claims 1 to 10, where the emission wavelength of the light source (LS) is in between 840 nm and 1610 nm.

12. A vehicle,
- an imaging system according to one of claims 1 to 11, and
- board electronics embedded in the vehicle, wherein:
- the imaging system is arranged to provide an output signal to the board electronics.

13. A detection method where a scene is illuminated with a light source (LS) emitting:
- a first light pulse in order to acquire a first image by a detector array (DA) having a constant sensitivity, and
- a second light pulse in order to acquire a second image by the detector array having a sensitivity increasing with a time and wherein the detector array, which comprises pixels (Px) with a built-in modulation function is operable to detect light and changing sensitivity or responsivity of pixels during the acquisition of a frame and wherein acquisition performed by detector array (DA) is synchronized with the light source (LS), and
wherein
- the modulation function is a monotonic function of time and monotonously increasing or decreasing.

14. The detection method according to claim 13, where the distance of objects of the scene is inferred from the ratio of the second image to the first image.

15. The detection method according to one of claims 13 or 14, wherein the scene is illuminated by a light source (LS) and the first and the second light pulse have identical duration and pulse height.

## Patentansprüche

1. Bildgebungssystem, umfassend:
- eine Lichtquelle (LS),
- eine Detektoranordnung (DA), die Pixel (Px) umfasst, wobei die Pixel eine eingebaute Modulationsfunktion aufweisen, die eine Empfindlichkeit oder ein Ansprechverhalten der Pixel während der Erfassung eines Frames verändert, und
- eine Synchronisationsschaltung (SC) zum Synchronisieren der von der Detektoranordnung (DA) durchgeführten Erfassung mit der Lichtquelle (LS), wobei die Lichtquelle so betrieben werden kann, dass sie Folgendes emittiert:
- einen ersten Lichtpuls, um ein erstes Bild durch ein Detektorarray (DA) mit konstanter Empfindlichkeit zu erfassen, und
- einen zweiten Lichtpuls, um ein zweites Bild durch das Detektorarray mit einer mit der Zeit zunehmenden Empfindlichkeit zu erfassen, und wobei
- die Modulationsfunktion eine monotone Funktion der Zeit und monoton ansteigend oder abfallend ist.

2. Bildgebungssystem nach Anspruch 1, wobei
- zumindest die Detektoranordnung (DA) und die Synchronisationsschaltung (SC) in einem gemeinsamen Chip (CH) integriert sind und/oder
- die Bildgebung ein Sensorgehäuse umfasst, das die Detektoranordnung (DA) und die Synchronisationsschaltung (SC), die in denselben Chip (CH) integriert sind, sowie die Lichtquelle (LS) umschließt.

3. Bildgebungssystem nach Anspruch 1 oder 2, wobei die Modulationsfunktion durch ein Modulationselement (ME) erreicht wird.

4. Bildgebungssystem nach Anspruch 3, wobei das Modulationselement (ME) einen Leckstrom einführt, der linear zu einer angelegten Spannung ist.

5. Bildgebungssystem nach einem der Ansprüche 1 bis 4, wobei die Pixel (Px) eine Polarisationsfunktion haben.

6. Bildgebungssystem nach Anspruch 5, wobei benachbarte Pixel (Px) orthogonale Polarisationsfunktionen aufweisen.

7. Bildgebungssystem nach einem der Ansprüche 4 bis 6, wobei ein durch das Modulationselement (ME) fließender Leckstrom zu Beginn eines Frames einen ersten Wert und am Ende des Frames einen zweiten Wert aufweist, wobei der erste Wert höher ist als der zweite Wert.

8. Bildgebungssystem nach einem der Ansprüche 4 bis 7, wobei ein durch das Modulationselement (ME) fließender Leckstrom während eines Frames B monoton von einem ersten Wert zu einem zweiten Wert abnimmt.

9. Bildgebungssystem nach einem der Ansprüche 4 bis 8, wobei das Modulationselement (ME) ein Transistor ist, beispielsweise ein Leckstromskontrolltransistor.

10. Bildgebungssystem nach einem der Ansprüche 1 bis 9, wobei die Emissionswellenlänge der Lichtquelle (LS) größer als 800 nm und kleiner als 10000 nm ist.

11. Bildgebungssystem nach einem der Ansprüche 1 bis 10, wobei die Emissionswellenlänge der Lichtquelle (LS) zwischen 840 nm und 1610 nm liegt.

12. Fahrzeug,
- ein Bildgebungssystem gemäß einem der Ansprüche 1 bis 11 und
- im Fahrzeug eingebettete Bordelektronik, wobei
- das Bildgebungssystem so angeordnet ist, dass es ein Ausgangssignal an die Bordelektronik liefert.

13. Ein Detektionsverfahren, bei dem eine Szene mit einer Lichtquelle (LS) beleuchtet wird, die
- einen ersten Lichtpuls, um ein erstes Bild durch eine Detektoranordnung (DA) mit konstanter Empfindlichkeit zu erfassen, und
- einen zweiten Lichtpuls, um ein zweites Bild durch die Detektoranordnung mit einer mit der Zeit zunehmenden Empfindlichkeit zu erfassen, emittiert, und wobei die Detektoranordnung, die Pixel (Px) mit einer eingebauten Modulationsfunktion umfasst, so betrieben werden kann, dass sie Licht und sich ändernde Empfindlichkeit oder sich änderndes Ansprechverhalten der Pixel während der Erfassung eines Frames erfasst, und wobei die durch die Detektoranordnung (DA) durchgeführte Erfassung mit der Lichtquelle (LS) synchronisiert ist, und wobei
- die Modulationsfunktion eine monotone Funktion der Zeit und monoton ansteigend oder abfallend ist.

14. Das Detektionsverfahren gemäß Anspruch 13, wobei der Abstand von Objekten der Szene aus dem Verhältnis des zweiten Bildes zum ersten Bild abgeleitet wird.

15. Detektionsverfahren nach einem der Ansprüche 13 oder 14, wobei die Szene durch eine Lichtquelle (LS) beleuchtet wird und der erste und der zweite Lichtpuls identische Dauer und Pulshöhe aufweisen.

## Revendications

1. Système d'imagerie comprenant:
- une source lumineuse (LS),
- un réseau de détecteurs (DA) qui comprend des pixels (Px), les pixels ayant une fonction de modulation intégrée modifiant la sensibilité ou la réactivité des pixels pendant l'acquisition d'une trame, et
- un circuit de synchronisation (SC) pour synchroniser l'acquisition effectuée par le réseau de détecteurs (DA) avec la source lumineuse (LS), la source lumineuse étant capable d'émettre:
- une première impulsion lumineuse pour acquérir une première image par un réseau de détecteurs (DA) ayant une sensibilité constante, et
- une deuxième impulsion lumineuse pour acquérir une deuxième image par le réseau de détecteurs ayant une sensibilité augmentant avec le temps, et dans lequel
- la fonction de modulation est une fonction monotone du temps et augmente ou diminue de manière monotone.

2. Système d'imagerie selon la revendication 1, dans lequel
- au moins le réseau de détecteurs (DA) et le circuit de synchronisation (SC) sont intégrés dans une même puce (CH) et/ou
- l'imagerie comprend un boîtier de capteur qui renferme le réseau de détecteurs (DA) et le circuit de synchronisation (SC) intégrés dans la même puce (CH) ainsi que la source lumineuse (LS).

3. Système d'imagerie selon la revendication 1 ou 2, dans lequel la fonction de modulation est obtenue par un élément de modulation (ME).

4. Système d'imagerie selon la revendication 3, dans lequel l'élément de modulation (ME) introduit un courant de fuite linéaire par rapport à une tension appliquée.

5. Système d'imagerie selon l'une des revendications 1 à 4, dans lequel les pixels (Px) ont une fonction de polarisation.

6. Système d'imagerie selon la revendication 5, dans lequel des pixels adjacents (Px) ont des fonctions de polarisation orthogonales.

7. Système d'imagerie selon l'une des revendications 4 à 6, dans lequel un courant de fuite qui circule à travers l'élément de modulation (ME) a une première valeur au début d'une trame et une deuxième valeur à la fin de la trame, la première valeur étant supérieure à la deuxième valeur.

8. Système d'imagerie selon l'une des revendications 4 à 7, dans lequel un courant de fuite qui circule à travers l'élément de modulation (ME) diminue de manière monotone d'une première valeur à une deuxième valeur pendant une trame B.

9. Système d'imagerie selon l'une des revendications 4 à 8, dans lequel l'élément de modulation (ME) est un transistor, tel qu'un transistor à contrôle de courant de fuite.

10. Système d'imagerie selon l'une des revendications 1 à 9, dans lequel la longueur d'onde d'émission de la source lumineuse (LS) est supérieure à 800 nm et inférieure à 10 000 nm.

11. Système d'imagerie selon l'une des revendications 1 à 10, dans lequel la longueur d'onde d'émission de la source lumineuse (LS) est comprise entre 840 nm et 1610 nm.

12. Véhicule,
- un système d'imagerie selon l'une des revendications 1 à 11, et
- une électronique embarquée intégrée dans le véhicule, dans lequel:
- le système d'imagerie est agencé pour fournir un signal de sortie à l'électronique embarquée.

13. Procédé de détection dans lequel une scène est éclairée par une source lumineuse (LS) émettant:
- une première impulsion lumineuse afin d'acquérir une première image par un réseau de détecteurs (DA) ayant une sensibilité constante, et
- une deuxième impulsion lumineuse afin d'acquérir une deuxième image par le réseau de détecteurs ayant une sensibilité augmentant avec le temps et dans lequel le réseau de détecteurs, qui comprend des pixels (Px) avec une fonction de modulation intégrée, est capable de détecter la lumière et la sensibilité ou la réactivité changeante des pixels pendant l'acquisition d'une trame et dans lequel l'acquisition effectuée par le réseau de détecteurs (DA) est synchronisée avec la source lumineuse (LS), et dans lequel
- la fonction de modulation est une fonction monotone du temps et augmente ou diminue de manière monotone.

14. Procédé de détection selon la revendication 13, dans lequel la distance des objets de la scène est déduite du rapport entre la deuxième image et la première image.

15. Procédé de détection selon l'une des revendications 13 ou 14, dans lequel la scène est éclairée par une source lumineuse (LS) et la première et la deuxième impulsions lumineuses ont une durée et une hauteur d'impulsion identiques.
